Europäisches Patentamt

European Patent Office

Office européen des brevets

(19)

(11) Numéro de publication: **0 081 414**
**B1**

(12) # FASCICULE DE BREVET EUROPEEN

(45) Date de publication du fascicule du brevet:
16.10.85

(51) Int. Cl.⁴: **H 01 L 23/48**, H 01 L 29/90, H 01 L 29/91, H 01 L 29/93

(21) Numéro de dépôt: 82402161.2

(22) Date de dépôt: 26.11.82

(54) **Dispositif semi-conducteur à faible capacité parasite muni de connexions externes prises au moyen de poutres.**

(30) Priorité: 09.12.81 FR 8123028

(43) Date de publication de la demande:
15.06.83 Bulletin 83/24

(45) Mention de la délivrance du brevet:
16.10.85 Bulletin 85/42

(84) Etats contractants désignés:
**DE GB NL SE**

(56) Documents cités:
**GB - A - 2 067 354**
**US - A - 4 097 890**
**US - A - 4 301 233**

(73) Titulaire: **THOMSON-CSF, 173, Boulevard Haussmann, F-75379 Paris Cedex 08 (FR)**

(72) Inventeur: **Henry, Raymond, THOMSON-CSF SCPI 173, bld. Haussmann, F-75379 Paris Cedex 08 (FR)**
Inventeur: **Bouvet, Jean-Victor, THOMSON-CSF SCPI 173, bld. Haussmann, F-75379 Paris Cedex 08 (FR)**

(74) Mandataire: **Taboureau, James et al, THOMSON-CSF SCPI 173, Bld Haussmann, F-75379 Paris Cedex 08 (FR)**

ACTORUM AG

## Description

La présente invention concerne un dispositif semiconducteur à faible capacité parasite, du type de ceux dont les connexions externes sont prises au moyen de poutres métalliques soudées à plat sur la pastille semiconductrice selon la technologie dite «beam lead».

Elle concerne plus particulièrement les dispositifs semiconducteurs travaillant à des fréquences égales ou supérieures à 1 GHz, pour lesquelles les capacités parasites entre au moins l'une des poutres ou d'un plot métallique et le substrat sont très fortement diminuées selon l'invention.

Sans que cela constitue une limite à l'invention, celle-ci sera exposée en s'appuyant sur le cas d'une diode munie de poutres métalliques, la diode étant à la base de tout composant semiconducteur plus complexe, tel que le transistor par exemple.

Toute diode, qu'elle soit à jonction, de type pn, ou Schottky, à métal semiconducteur, comporte un substrat qui supporte la ou les couches actives de la diode, de faible épaisseur par rapport à celle du substrat. Celui-ci est lui-même constitué d'un matériau semiconducteur, qu'on a choisi dopé, de type n + par exemple — sans que ceci soit limitatif — car ceci facilite l'élaboration de la diode, le substrat apportant d'une part le support mécanique et d'autre part au moins une couche active de la diode.

Etant donné par ailleurs que les connexions extérieures sont, comme cela a été précisé, des poutres métalliques fixées à plat sur la surface de la pastille et qu'au moins une poutre est soutenue par une couche d'isolant, hors de la région de contact, de façon à ne pas court-circuiter le contact avec la couche active sous-jacente à la poutre, il se forme des condensateurs parasites ayant une poutre comme première armature, le substrat conducteur comme deuxième armature et la couche isolante comme diélectrique.

Un perfectionnement déjà connu consiste à creuser un caisson dans le matériau semiconducteur — par tout procédé connu de l'homme de l'art — sous une partie de la poutre considérée et à remplacer le matériau semiconducteur manquant dans ce caisson par un matériau isolant, du verre par exemple. L'épaisseur de diélectrique du condensateur parasite est ainsi augmentée ce qui va dans le sens de la diminution de capacité. Par contre, la surface d'armature constituée non plus par une surface de substrat sensiblement égale à la surface de la poutre, mais constituée désormais par la partie concernée du substrat conducteur dans la cuvette creusée, est augmentée, ce qui va dans le sens contraire d'augmentation de la capacité parasite.

Selon l'invention, la partie active d'un dispositif semiconducteur, doté de connexions extérieures par poutres métalliques dont une au moins repose sur un caisson isolant est constituée par une très faible épaisseur de matériau semiconducteur, cette épaisseur correspondant au plus à environ 3 fois l'effet de peau, ce matériau semiconducteur, étant lui-même supporté par un substrat isolant. Ainsi, la majeure partie de l'armature de condensateur constituée par le substrat disparaît, puisque le substrat est isolant et que ne demeure qu'une faible épaisseur de matériau semiconducteur, ce qui diminue la capacité parasite du dispositif semiconducteur.

De façon plus précise, l'invention concerne un dispositif semiconducteur à faible capacité parasite, muni de connexions externes prises au moyen de poutres métalliques fixées à plat sur la surface de la pastille seminconductrice, dont l'une au moins est, dans sa partie extérieure au contact qu'elle assure en surface de la pastille, électriquement isolée et mécaniquement soutenue par un matériau isolant de remplissage d'un sillon s'étendant depuis la surface de la pastille jusque dans le substrat du dispositif semiconducteur, ce dispositif semiconducteur étant caractérisé en ce que son substrat est en matériau électriquement isolant ($\rho \geqslant 4000 \, \Omega \cdot cm$), et en ce qu'une couche semiconductrice, comprise entre le substrat isolant et les couches superficielles formant au moins une jonction du dispositif semiconducteur, a une épaisseur faible par rapport à l'épaisseur des matériaux de remplissage du sillon.

L'invention sera mieux comprise par le description qui suit d'exemples de réalisation, lesquels s'appuient sur les figures annexées qui représentent:

fig. 1: une vue en coupe d'une diode Schottky selon l'art connu;

fig. 2: une vue en coupe d'une diode Schottky selon un perfectionnement de l'art connu;

fig. 3: une vue en coupe d'une diode Schottky selon l'invention;

fig. 4: une vue en coupe d'une diode à jonction selon l'invention.

En vue de rendre le texte plus clair et les dessins plus simples, l'invention sera exposée, comme il a été dit, en s'appuyant sur le cas d'une diode. Elle concerne aussi bien les diodes à jonction PN que les diodes Schottky, mais ne concerne que les matériaux, pour le substrat, pouvant être obtenus avec une résistivité $\rho$ suffisamment élevée pour que l'on ait $\rho \, \epsilon \, \omega \gg 1$ avec:

$\epsilon$ = constante diélectrique du matériau

$\omega$ = pulsation = $2\pi \times$ fréquence de travail.

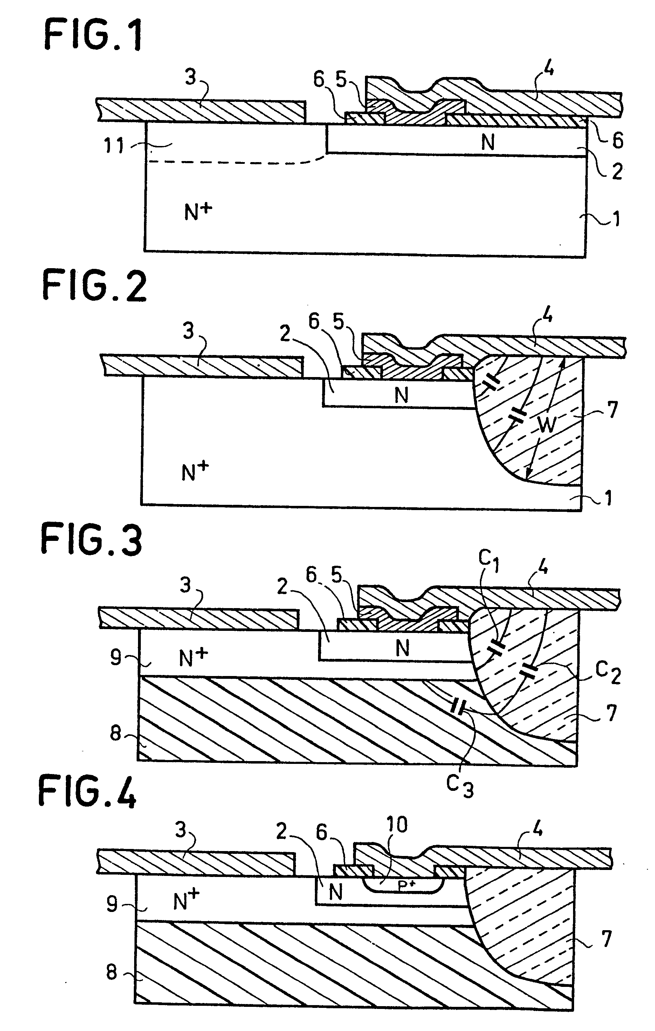

Ainsi, la figure 1 représente la vue en coupe d'une diode Schottky selon l'art connu. Le substrat 1 de cette diode est un matériau semiconducteur dopé de type N + par exemple et sur lequel a été épitaxié, une couche 2 de type N à travers laquelle on a localement implanté ou diffusé une zone 11 de type N + d'épaisseur égale ou supérieure à la zone N d'origine se raccordant donc à la zone N + sans discontinuité. Un premier contact ohmique, le contacte de cathode 3 est assuré sur la zone 11 par une poutre métallique réalisée selon la chaîne SiPt - Ti - Pt - Au, si le matériau de base de la diode est du silicium. La poutre 3 peut également être réalisée à la surface du substrat 1, dans une région où la couche N 2 a été éliminé sans nuire pratiquement à la planéité car son épaisseur est en général inférieure ou égale à 1 $\mu$m. Le fait que sous la poutre 3 le matériau soit de type N + est nécessaire pour pouvoir réaliser le contact ohmique sur le substrat N +.

Le second contact, ou contact d'anode 4, est réalisé par exemple au moyen de titane-platine et d'or, mais une épaisseur de métal 5 assurant le contact Schottky, par exemple une première couche de titane ou de chrome, ou molybdène ou palladium, ou tungstène, ou platine..., suivant la valeur du seuil désirée pour la caractéristique directe, est intercalée entre la poutre 4 et la région N 2.

De façon à éviter que la poutre d'anode 4 ne soit en contact avec la région N 2 en dehors du contact Schottky 5, la poutre d'anode est mécaniquement supportée et électriquement isolée par une couche d'un isolant 6, qui est par exemple de l'oxyde de silicium.

Du fait que les contacts externes sont dans le cas présent pris par des poutres métalliques fixées à plat sur la surface supérieure du dispositif semiconducteur, il se forme un système de condensateurs parasites entre d'une part, l'électrode d'anode 4, qui est un ruban métallique, et d'autre part, la couche N 2 et le substrat $n^+$ 1, la couche 6 d'isolant étant le diélectrique commun des différents condensateurs parasites.

Ces différents condensateurs parasites ont une capacité relativement très importante, aux fréquences de travail, c'est-à-dire largement supérieures à 1 GHz, du fait de l'épaisseur très faible de la couche de diélectrique 6, et du fait de la relativement grande surface de la poutre métallique 4, surface nécessaire pour avoir une bonne solidité mécanique de l'ensemble, avoir une bonne maniabilité du dispositif semiconducteur fabriqué, et assurer une inductance série faible en hyperfréquence.

La surface des armatures de ces condensateurs est assez précisément définie par la surface de la poutre 4, mais relativement moins définie du côté de la seconde armature par les surfaces des couches $n^+$ 1 et n 2, qui participent à la seconde armature de ces condensateurs parasites.

La fig. 2 représente une amélioration connue pour diminuer la capacité parasite de diodes dotées de connexions beam lead.

Par rapport à la fig. 1, on voit sur la fig. 2 qu'un caisson 7 à été creusé dans le substrat 1 et dans la couche n 2, sous la poutre d'anode 4, ce caisson étant ensuite rempli d'un matériau diélectrique, tel que par exemple du verre qui a été amené à fusion. Afin de diminuer au maximum les capacités parasites, ce caisson est amené au plus près possible du contact Schottky, au voisinage du point commun entre le matériau semiconducteur, le diélectrique et la poutre, et de plus, la poutre est elle-même réduite en surface au-dessus et au voisinage de la jonction Schottky, ce qui diminue d'autant l'armature du condensateur. Le caisson est réalisé de telle façon qu'il puisse contenir un diélectrique tel que du verre en poudre, à coefficient de dilatation accordé à celui du semiconducteur, et qui est ensuite fondu.

Les condensateurs parasites schématiquement représentés sur la fig. 2 sont donc diminué puisque l'épaisseur de diélectrique 7 est fortement augmentée, la valeur de la capacité parasite globale de la diode considérée étant proportionnelle à la surface S des électrodes, c'est-à-dire poutre et substrat et inversement proportionnelle à l'épaisseur W de diélectrique 7:

$$c_{parasite} \sim \frac{d.S}{W}$$

avec $\epsilon_d$ = constante diélectrique du verre $\simeq 6\,\epsilon_o$, $\epsilon_o$ étant la constante diélectrique de l'air.

Ce perfectionnement diminue considérablement la capacité parasite d'une diode Schottky, puisque l'épaisseur de verre est couramment de 10 à 30 microns, au lieu d'un micron environ de silice dans le cas précédent de la fig. 1. Par contre, le substrat $N^+$ 1 étant conducteur de l'électricité, la surface offerte par celui-ci pour former l'armature d'un condensateur parasite correspond désormais à une cuvette, plus grande que l'ombre projetée par la poutre sur le substrat dans le cas de figure précédent. Par conséquent, le bord même de la cuvette, en augmentant la surface d'armature possible, tend à augmenter la capacité parasite car de plus, à ce bord, correspond une valeur de W plus faible.

La fig. 3 représente une diode Schottky selon l'invention.

Sur un substrat 8, isolant et quasi intrinsèque, c'est-à-dire de résistivité supérieure ou égale à 4000 $\Omega \cdot$ cm est réalisée une couche 9 d'un matériau conducteur, de type $N^+$ par exemple dans le cas présent. S'il s'agit de silicium monocristallin de haute résistivité on à réalisé la couche 9 par épitaxie; s'il s'agit de silicium polycristallin de haute résistivité, par exemple par dopage oxygène, on a déposé celui-ci sur un substrat épais de $N^+$ dont on a, après, diminué l'épaisseur par un procédé connu, rodage, attaque chimique, ... Cette couche 9 a une épaisseur de l'ordre de 1 à 3 fois l'effet de peau à la fréquence de travail du dispositif semiconducteur, soit de 6 à 20 $\mu$m pour une utilisation à 100 GHz.

Par la suite est réalisée par épitaxie une couche 2 de type N, la couche 2 et la couche 9 ayant même surface supérieure comme on l'a expliqué plus haut (par diffusion ou implantation localisée d'une zone N + ). Après masquage adéquat, la couche d'isolant 6 est déposée sur la couche N 2 et la diode sera achevée après creusement d'un sillon 7 rempli de verre, comme dans le cas du perfectionnement connu décrit en fig. 2, dépôt du métal de contact Schottky 5, et croissance des poutres 3 et 4 de prises de contact de cathode et d'anode.

La couche active $N^+$, repérée 9, est du même type que celle du substrat 1 de la fig. 2 par exemple, mais elle assure désormais une double fonction; sous la poutre de cathode 3, il est nécessaire que le semiconducteur soit de type $N^+$ pour prendre un contact ohmique, et sous la couche N 2 une certaine épaisseur, de l'ordre de 1 à 3 fois l'effet de peau, est nécessaire pour qu'il n'y ait pas résistance au passage du courant entre anode et cathode.

En ce qui concerne les capacités parasites développées entre la poutre d'anode 4 d'une part et les différentes couches de la diode d'autre part, la capacité parasite entre poutre 4 et la couche N 2 demeure comme dans le cas précédent. Par contre, si on suppose que le substrat 8 est en matériau conducteur, comme dans le cas de la fig. 2, on a alors une capacité parasite $C_p$ égale à $C_p = C_1 + C_2$, $C_1$ étant la capacité entre poutre 4 et couche $N^+$ 9 et $C_2$ étant la capacité entre poutre 4 et couche 8 supposée conductrice.

Mais selon l'invention, la couche 8 étant isolante ou quasi-isolante, la capacite $C_2$ est remplacée par deux capacités montées en série $C_2$ et $C_3$, $C_3$ étant la capacité entre la paroi du sillon de verre 7 et la surface de séparation entre le substrat isolant 8 e la couche semiconductrice $N^{+}$ 9. Dans ce cas, la capacité parasite $C'_p$ est égale à:

$$C'_p = C_1 + \frac{1}{1(C_2 + 1/C_3)} = C_1 + C_2 \left(\frac{C_3}{C_2 + C_3}\right)$$

mais comme $C_3 \ll C_2 = C_3$, il s'ensuit que $C'_p \ll C_p$.

Ainsi, selon le perfectionnement de l'invention, la capacité parasite $C'_p$ entre la poutre d'anode 4 et le corps de la diode n'est plus que la somme de la capacité parasite entre poutre et couche N 2 de 0,5 $\mu$m d'épaisseur et de la capacité $C_1$ entre poutre et couche $N^+$ 9 de 6 à 20 $\mu$m d'épaisseur, les deux étant très faibles.

L'invention jusqu'à présent, a été exposée en s'appuyant sur le cas d'une diode Schottky. La fig. 4 représente une application de l'invention au cas d'une diode à jonction PN par exemple.

Le rapprochement des figures 4 et 3 permet de constater que la diode à jonction de la fig. 4 est réalisée selon un procédé très proche de celui de la diode Schottky de la fig. 3, mais que la couche de métal de contact Schottky 5 en fig. 3, est remplacée par une diffusion ou une implantation 10, de conductivité P+ dans le cas présent puisque des conductivités N+ et N ont été choisies pour représenter l'invention. L'important est que la création de capacités parasites est évitée en remplaçant le substrat habituellement conducteur par un substrat isolant, et en ne maintenant comme couche très dopée qu'une épaisseur minimale correspondant à l'épaisseur de peau nécessaire pour que la diode ne présente pas une résistance de passage importante.

Bien que l'invention ait été décrite en s'appuyant sur le cas de diodes, il est évident que son application à des dispositifs plus complexes tels que transistors latéraux dotés de trosi connexions externes sous forme de poutre fixées à plat sur la pastille, ainsi que l'adaptation à des matériaux de genre ou de conductivité différente entrent dans le domaine de l'invention, qui est précisée par les revendications ci-après.

## Revendications

1. Dispositif semiconducteur à faible capacité parasite, muni de connexions externes prises au moyen de poutres métalliques (3, 4) fixées à plat sur la surface de la pastille semiconductrice, dont l'une au moins (4), est, dans sa partie extérieure au contact qu'elle assure en surface de la pastille, électriquement isolée et mécaniquement soutenue par un matériau isolant de remplissage d'un sillon (7) s'étendant depuis la surface de la pastille jusque dans le substrat (8) du dispositif semiconducteur, ce dispositif semiconducteur étant caractérisé en ce que son substrat (8) est en matériau électriquement isolant ($\rho > 4000\,\Omega \cdot cm$), et en ce qu'une couche (9) semiconductrice, comprise entre le substrat isolant (8) et les couches superficielles (2, 5 ou 10) formant au moins une jonction du dispositif semiconducteur, a une épaisseur faible par rapport à l'épaisseur du matériau de remplissage du sillon (7).

2. Dispositif semiconducteur selon la revendication 1, caractérisé en ce que le substrat (8) est en silicium monocristallin ou polycristallin dopé pour assurer une résistivité très élevée.

3. Dispositif semiconducteur selon la revendication 1, caractérisé en ce que le substrat (8) est en matériau de la famille III-V, parmi GaAs et ses alliages dopé pour assurer une résistivité très élevée.

4. Dispositif semiconducteur selon la revendication 1, caractérisé en ce que le substrat isolant (8) supporte une première couche semiconductrice (9) dans l'épaisseur de laquelle est réalisée une deuxième couche semiconductrice (2), la première couche (9) remplissant une double fonction: dans une première région, elle permet une prise de contact ohmique avec une connexion externe par poutre (3), et dans une deuxième région, située entre la deuxième couche (2) et le substrat (8) elle améliore la transconductance du dispositif semiconducteur, entre ses deux connexions externes.

## Patentansprüche

1. Halbleitervorrichtung mit geringer Störkapazität und versehen mit äusseren Anschlüssen, die über metallische Leiterstreifen (3, 4) herausgeführt sind, welche flach an der Oberfläche des Halbleiterplättchens befestigt sind und wovon wenigstens eine (4) an ihrem ausserhalb ihres Bereiches, durch den der Kontakt an der Oberfläche des Plättchens gewährleistet wird, befindlichen Teil elektrisch isoliert und mechanisch gehalten wird durch ein Isoliermaterial zum Ausfüllen einer Rille (7), welche sich von der Oberfläche des Plättchens bis in das Substrat (8) der Halbleitervorrichtung erstreckt, wobei diese Halbleitervorrichtung dadurch gekennzeichnet ist, dass ihr Substrat (8) aus einem elektrisch isolierenden Material ($\rho > 4000\,\Omega \cdot cm$) ist und dass eine Halbleiterschicht (9), welche zwischen dem Isoliersubstrat (8) und den Oberflächenschichten (2, 5 oder 10) enthalten ist, die wenigstens einen Übergang der Halbleitervorrichtung bilden, eine Dicke aufweist, die gering gegenüber der Dicke des Materials zum Ausfüllen der Rille (7) ist.

2. Halbleitervorrichtung nach Anspruch 1, dadurch gekennzeichnet, dass das Substrat (8) aus monokristallinem oder polykristallinem dotierten Silizium ist, um einen sehr hohen spezifischen Widerstand zu gewährleisten.

3. Halbleitervorrichtung nach Anspruch 1, dadurch gekennzeichnet, dass das Substrat (8) aus einem Material der Gruppe III-V besteht, unter anderem GaAs und seinen Legierungen, welches zur Gewährleistung eines sehr hohen spezifischen Widerstandes dotiert ist.

4. Halbleitervorrichtung nach Anspruch 1, dadurch gekennzeichnet, dass das Isoliersubstrat (8) eine erste Halbleiterschicht (9) trägt, in deren Dicke eine zweite Halbleiterschicht (2) gebildet ist, wobei die erste Schicht (9) eine doppelte Funktion ausübt: In einem ersten Gebiet ermöglicht sie eine ohmsche Kontaktbildung mit einem äusseren Anschluss über einen Leiterstreifen (3); und in einem zweiten Gebiet, welches zwischen der zweiten Schicht (2) und dem Substrat (8) liegt, verbessert sie die Transkonduktanz der Halbleitervorrichtung zwischen ihren äusseren Anschlüssen.

## Claims

1. Semiconducteur device having a low parasitic capacity and provided with external connections derived by means of metallic beams (3, 4) fixed in flat manner on the surface of the semiconductor chip and at least one of which (4), in its portion exterior to the contact ensured thereby at the surface of the chip, is electrically insulated and mechanically supported by an insulating material filling a groove (7) extending from the surface of the chip to the substrate (8) of the semiconductor device, this semiconductor device being characterized in that its substrate (8) is of an electrically insulating material ($\rho > 4000\,\Omega \cdot$ cm) and in that a semiconductor layer (9) comprised between the insulating substrate (8) and the superficial layers (2, 5 or 10) forming at least one junction of the semiconductor device has a thickness which is small in comparison to the thickness of the filling material of the groove (7).

2. Semiconductor device according to claim 1, characterized in that the substrate (8) is of monocrystalline or polycrystalline doped silicon to ensure a very high resistivity.

3. Semiconductor device according to claim 1, characterized in that the substrate (8) is of a material of the group III-V, among GaAs and its alloys, which is doped in order to ensure a very high resistivity.

4. Semiconductor device according to claim 1, characterized in that the insulating substrate (8) carries a first semiconductor layer (9) in the thickness of which a second semiconductor layer (2) is formed, the first layer (9) having a double function: In a first region it permits the ohmic contacting of an external connection through a beam (3), and in a second region lying between the second layer (2) and the substrate (8) it improves the transconductance of the semiconductor device between its external connections.

# FIG.1

3
6 5
4
6
11
N
6
2
N⁺
1

# FIG.2

3
2 6 5
4
N
7
W
N⁺
1

# FIG.3

C₁
3
2 6 5
4
9
N
8
N⁺
C₂
7
C₃

# FIG.4

3
2 6
10
4
9
N
N⁺
P⁺
7
8